# EUROPEAN PATENT SPECIFICATION

(11) **EP 2 744 924 B1**
(45) Date of publication and mention of the grant of the patent: **18.11.2015**
(21) Application number: 12784055.1
(22) Date of filing: 14.08.2012
(51) Int. Cl.: C23C 16/455, C23C 16/509, C23C 16/458

(54) **GAS DISTRIBUTION SYSTEM FOR A REACTION CHAMBER**
GASVERTEILUNGSSYSTEM FÜR EINE REAKTIONSKAMMER
SYSTÈME DE DISTRIBUTION DE GAZ POUR UNE CHAMBRE À RÉACTION

(30) Priority: 15.08.2011 HU P1100436
(43) Date of publication of application: 25.06.2014
(73) Proprietor: Ecosolifer AG, 6062 Sarnen (CH)
(72) Inventor: VADADI, Zsolt, H-1022 Budapest (HU); STRAUSZ, Tamás, H-2040 Budaörs (HU); NÉMETH, Péter, H-9700 Szombathely (HU)
(74) Representative: Lantos, Mihaly
(86) International application number: PCT/HU2012/000073
(87) International publication number: WO 2013/024314

(56) References cited:
- WO-A1-2009/144371
- CN-A- 101 626 049
- US-A- 5 036 794
- US-A- 5 330 578
- US-A1- 2010 092 697

## Description

The present invention refers to a gas distribution system for use in a reaction chamber, in particular in a thin layer deposition chamber to provide homogeneous gas flow, The reaction chamber serves for the deposition of a semiconductor layer or layer structure on the plurality of substrate surfaces wherein the chamber comprises a body with an inner volume and an upper lid and a closing bottom lid, in the inner volume rectangular substrates are arranged spaced apart from each other and metal electrodes suitable for providing high-frequency electromagnetic field in order to deposit a thin material layer are disposed between the substrates; each electrode is disposed in a spaced-apart relationship adjacent to the surface of a substrate not to be deposited and the space extending between the substrate surfaces to be deposited provide flow channels making available the laminar flow of reaction gases between two opposite sides of the chamber, the opposite electrodes are connected to a high-frequency generator and the closed inner volume of the chamber is provided with a heating element, further the gas distribution system has an inlet channel, a distribution chamber and a distribution plate and further a collecting plate, collecting chamber and an outlet channel.

Korean patent application No. KR 2009 0066631 concerns a thin layer type solar cell manufacturing apparatus. Here small size substrates are placed onto a tray and introduced into a reaction chamber where they are subject of a chemical vapor deposition process. On the gas inlet side the free-jet gas flow enters a distribution chamber. The gas is guided further from the distribution chamber and is spread by a suitable gas distribution sieve.

An example for the so called batch-processing methods, which are applied in the manufacturing of thin layer solar cells to simultaneously deposit various layers onto a plurality of large substrates, is described in Chinese patent application CN 101626049, wherein in the manufacturing process of a film solar cell substrates are mounted on respective surfaces of a plurality of electrode plates in a reaction chamber, then a gas mixture is introduced into the chamber and an RF plasma discharge is created in the chamber to produce an amorphous silicon-germanium layer. Gas is lead into the chamber through an inlet channel. Reaction gases enter the volume between the substrates and the inlet channel as a free-jet, this volume operating as a distribution chamber, and gases diffuse into the spaces extending between the parallel substrates without a distribution sieve.

In the document WO 2009/144371 A1 a reaction chamber is shown that comprises a plurality of spaced substrates which define respective gas flow channels in the gaps between the substrates. In this document there are no electrodes between the substrates

Document US5036794 presents a gas distribution system to be used in a reaction chamber for substrates in batches, comprising a gas inlet a distribution chamber with plate and an outlet with a collecting chamber with plate. A mixing chamber separated from the the distribution chamber is also present.

In all of the several embodiments of this document there is an expansion volume above the substrates that receives the gas inlet conduits which are connected with the in-feed line. The expansion volume is continued in the direction of the gas flow by a distribution part which is a mesh or a perforated plate and which is arranged across the flow direction. After this mesh the gas is not distributed individually among the substrates, therefore the gas flow will be different between the central and lateral zones. The main problem of the prior art solutions is that homogeneous distribution of the reaction gas flow is not solved. Presence of the sieve itself is not satisfactory to homogenize the reaction gas. On the other hand when said distribution sieve is applied there is a problem (this problem is even more pronounced without a sieve) that the reaction gas does not diffuse homogeneously into the volumes between the substrates - i.e. in the regions opposite to the inlet channel a larger amount and in the regions closer to the edges of the chamber a smaller amount of material can spread in between the substrates. This leads to inhomogeneous reaction conditions and finally results in layers with non-homogeneous quality and/or uneven thickness. This problem appears to be more problematic as the size of the chamber increases, since at the edges excessive differences in the length of the flow path may arise.

Thus, object of the present invention is to provide a gas distribution system in a reaction chamber for thin layer deposition, which system is capable to ensure more homogeneous gas flow over the prior art, and layers of more homogeneous thickness and better quality can be formed on every single substrate placed into the inner volume of the chamber.

According to the invention the above objects are achieved by a gas distribution system for use in a reaction chamber, the chamber comprising a body with an inner volume and an upper lid and a closing bottom lid, in the inner volume rectangular substrates are arranged spaced apart from each other and electrodes suitable for providing high-frequency electromagnetic field in order to deposit a thin material layer are disposed between the substrates; each electrode is disposed in a spaced-apart relationship adjacent to the surface of a substrate not to be deposited and the spaces extending between the substrate surfaces to be deposited provide flow channels making available the laminar flow of reaction gases between two opposite sides of the chamber, the opposite electrodes are connected to a high-frequency generator and the closed inner volume of the chamber is provided with a heating element, further the gas distribution system has an inlet channel, a distribution chamber and a distribution plate and further a collecting plate, collecting chamber and an outlet channel, wherein between the inlet channel and the distribution chamber there is disposed (i) a mixing chamber for improving the homogeneous blending of reaction gases and the mixing chamber is separated from the distribution chamber by a wall portion and (ii) conduits for improving the homogeneous blending of reaction gases having their first end in the mixing chamber and their terminal end in the distribution chamber.

According to the invention between the distribution chamber and the mixing chamber the direct gas communication is prevented, and individual conduits are disposed between the two chambers resulting in more homogeneous gas flow, since the conduits open into smaller sub-areas.

A preferred embodiment of the invention is hereinafter described in detail on the basis of the attached drawing wherein in
Fig. 1 a reaction chamber arranged on a structure of metal profiles is shown in perspective view,
Fig. 2 is a top view of the supporting frames which are placed adjacent to each other and in which the substrates will be inserted, in
Fig. 3 a loading container containing a plurality of adjacent supporting frames is shown in a perspective top view, in
Fig. 4 is a perspective, partially cut-out sectional view of the reaction chamber, wherein the chamber is rotated by -90° with respect to the view of Fig. 1., wherein the cut-out is made along two sidewalls of the chamber, in
Fig. 5 is a perspective, partially cut-out sectional view of the reaction chamber, wherein the chamber is rotated by -90° with respect to the view of Fig. 1., wherein the cut-out is made along one of the sidewalls and the upper lid of the chamber, in
Fig. 6 a diagrammatical view represents the position of the gas distribution system relative to the chamber, in
Fig. 7 the geometrical arrangement of the gas distributing channels is shown.

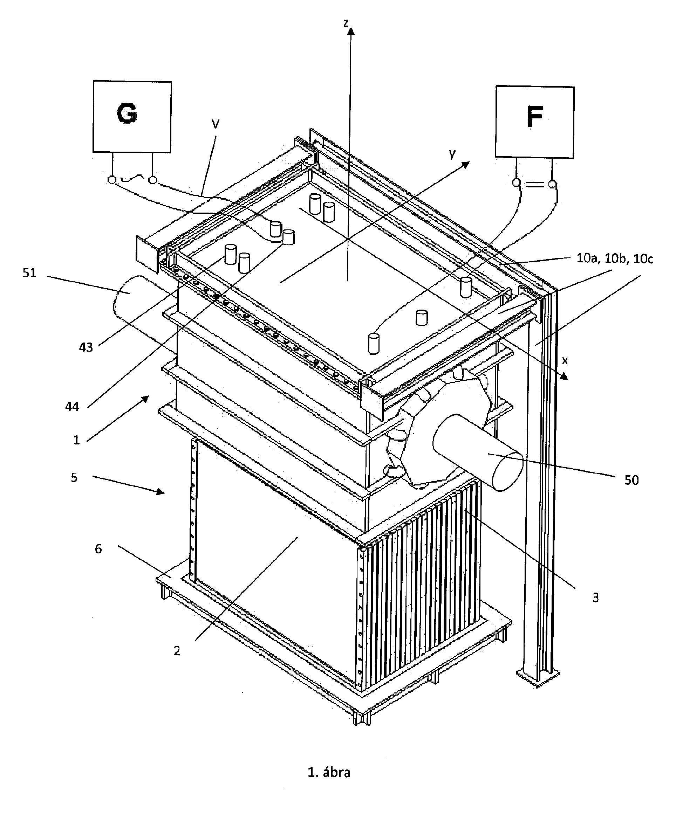

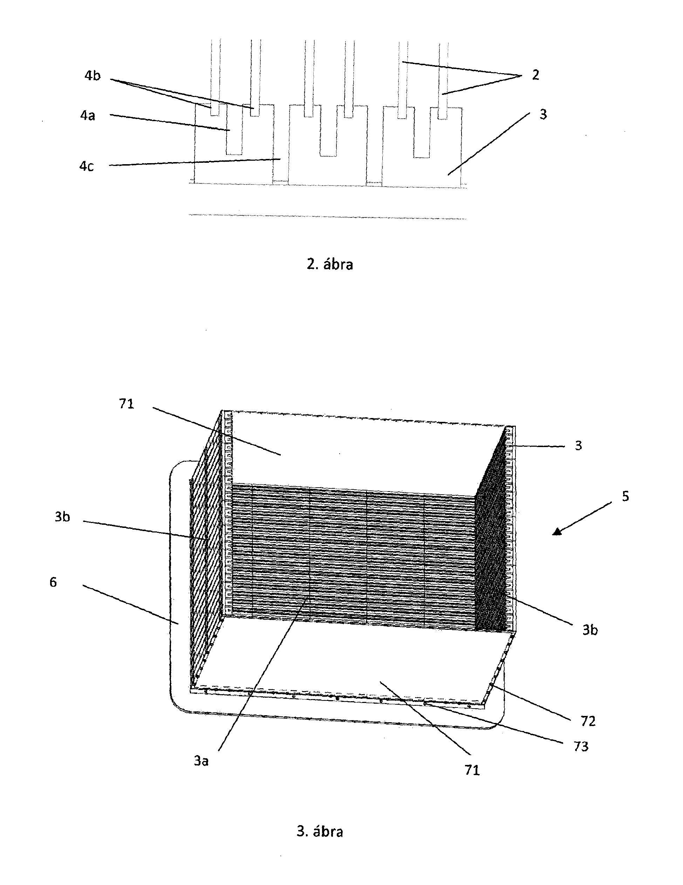

The reaction chamber 1 of fig. 1 has a framework made of 10a, 10b, 10c consoles. The 10a, 10b, 10c consoles are perpendicular to each other and are arranged along x, y and z directions, respectively. Dimensions and materials of the 10a, 10b, 10c consoles are selected so as to have sufficiently large load bearing capacity for holding the reaction chamber 1 which is very heavy in its loaded state. The respective walls provide (not shown in the drawing) an air tight closure of the reaction chamber 1 and during operation in the inside of the reaction chamber 1 a background pressure lower than the atmospheric pressure is present for promoting the reaction. The inner volume of the reaction chamber 1 comprises a structure made up of parallel, spaced apart plates. Said inner structure is made up partially by substrates 2, substantially rectangular glass plates - depicted in the enlarged partial view of Fig. 2 - wherein on one of the surfaces of the glass plates a semiconductor thin layer or thin layer structure is to be deposited in the reaction chamber 1, for example by a CVD process and consequently on said plates photovoltaic devices are formed. The thin layer structure may comprise layers made of different materials than semiconductors, which layers are built in a separate deposition step in the same or in a different reaction chamber 1. Such deposition step may comprise e.g. the formation of a slightly conducting layer on top of the active surface of the glass substrates 2. In Fig. 1 it is schematically shown that the substrates 2 are surrounded and supported along their side edges and along their bottom by supporting frames 3, wherein the plurality of frames forms an interconnected supporting structure. This structure is engaged with the bottom closing lid 6 of the reaction chamber 1 and this whole mechanical structure as a loading container 5 can be loaded in a properly guided manner into the reaction chamber 1 from the bottom, upwards along the z direction and when the layers are deposited, the loading container can be unloaded. In Fig. 1 the whole structure is shown at the beginning of the loading step.

In the same figure there is shown the upper lid of the reaction chamber 1 with connectors V to which a heater F and a generator G is connected via wiring. The heater F is connected by means of connecting elements 43 which also have a function of threaded rods. A further connecting element 44 protruding from the upper lid of the reaction chamber 1 is used for the connection of the radio frequency generator G. On the upper lid of the reaction chamber 1 a plurality of such threaded rod 43 and connecting element 44 is arranged in a manner to be described later in detail, however, in this diagrammatic view only three of them is shown in order to schematically represent the connection of the heater F and the generator G.

On the two opposite sidewalls of the reaction chamber 1 which are perpendicular to the x direction an inlet channel 50 for introducing the reaction gases and an outlet channel 51 for removing the reaction byproducts are arranged. Between the inlet channel 50 and the outlet channel 51 flow direction of gases is parallel to the plane of substrates 2.

Fig. 2 is a top view of an enlarged section of the supporting frames 3 in which the substrates 2 are inserted. In the inventive batch-processing equipment applicable to simultaneously handle a plurality of large 2 substrates a number of supporting frames 3 are placed adjacent to each other among which three is shown in Fig. 2. Each supporting frame 3 comprises three recesses: two recesses 4b with identical shape and thickness, and a third recess 4a formed between said two recesses 4b and being deeper and having a larger width than said two recesses 4b. Recesses 4b have a dimension which makes them eligible to insert substrates 2, e.g. glass plates used as substrates which snugly fit into them. Thickness of the substrates is between about 0.5 mm and 5 mm, preferably 2 mm, thus the width of said two recesses 4b is also in this range. The actual width of recess 4b must be formed in advance, e.g. by etching, according to the actual size of substrates 2 to be used in the apparatus. The supporting frames 3 are made of an electrically insulating and mechanically rigid material, which also have sufficient resistance against the compositions participating in the reaction to be carried out in the inner volume of the reaction chamber 1 and can also withstand high pressure and high temperature being present in the chamber. The supporting frames 3 are placed adjacent to each other in a periodic structure. In Fig. 2 going from left to right first comes a recess 4b which belongs to a first supporting frame 3, then recess 4a and again recess 4b belonging to the same frame is seen, subsequently we see a very narrow gap 4c dividing the first supporting frame 3 from the next neighbouring supporting frame 3, then recess 4b, recess 4a and again recess 4b of the neighbouring supporting frame 3 is seen etc.

In Fig. 3 the loading container 5 to be introduced into the reaction chamber 1 is shown in elevational perspective view from above and for the sake of better visibility some details are hidden. For example the substrates 2 which are supported in the recesses are not seen. Each supporting frame 3 consists of two lateral frame parts 3b and a bottom frame part 3a which together are formed as a single, rigid mechanical structure. The supporting frame 3 is open from above, thus it supports the substrates 2 only on the bottom and from the sides. This is particularly important, since the substrates 2 are inserted into the recesses 4b of the supporting frame 3 from the top side which is left open.

In the loading container 5 built up by the plurality of supporting frames 3 - using the reference signs of Fig. 2 - the following periodic structure is seen: a recess 4b of a supporting frame 3, then a recess 4a and again a recess 4b, then a small gap 4c between two adjacent supporting frames 3 and in a given loading container 5 this period is repeated in a finite number. The number of supporting frames 3 is determined by practical aspects, their number is preferably 25 to 50. In this case the number of substrates 2 to be loaded is twice the number of frames. The supporting frames 3 in the loading container 5 have the same dimensions. The supporting frames 3 and their recesses can firmly support the large glass plates of the substrates 2 during loading and unloading operations and the reaction. Lateral side parts 3b of the supporting frames 3 are slightly longer than the height of substrates 2; whereas the bottom frame parts 3a of the supporting frames 3 are slightly longer than the width of substrates 2. Size of the substrates 2 corresponds to the size foreseen for the devices to be fabricated and can be set to different values. The most preferred range is between 50 cm x 75 cm and 150 cm x 200 cm; a very frequently used dimension is 100 cm x 150 cm.

The supporting frames 3 which consist of more frame parts are made of an electrically insulating material. Such materials can be chosen among plastics or ceramics, e.g. alumina or Teflon, but for this purpose other electrically insulating materials with high mechanical hardness can be used such as glass, minerals, composite materials etc. It is not excluded to make the supporting frames 3 of metal, however, in this case the metal surface must be covered by an insulation layer.

The bottom of the loading container 5 is fixed to the bottom closing lid 6 which is disposed below the bottom frame parts 3a, is joined to the supporting frames 3 and has a broad edge portion. In order to provide rigidity of the structure the two supporting frames 3 laterally closing the loading container 5 are connected to fastening plates 71 and on the rear side or in the bulk of the upwards directed lateral frame parts 3b through holes are provide through which threaded bolts 72 are guided in the transversal direction, the ends of the bolts are fastened by means of nuts, and these bolts hold all lateral frame parts 3b together. Similarly, on the bottom the bottom frame parts 3a are hold together by threaded bolts 73 and the corresponding nuts. The whole structure is hold together on the bottom by the bottom closing lid 6.

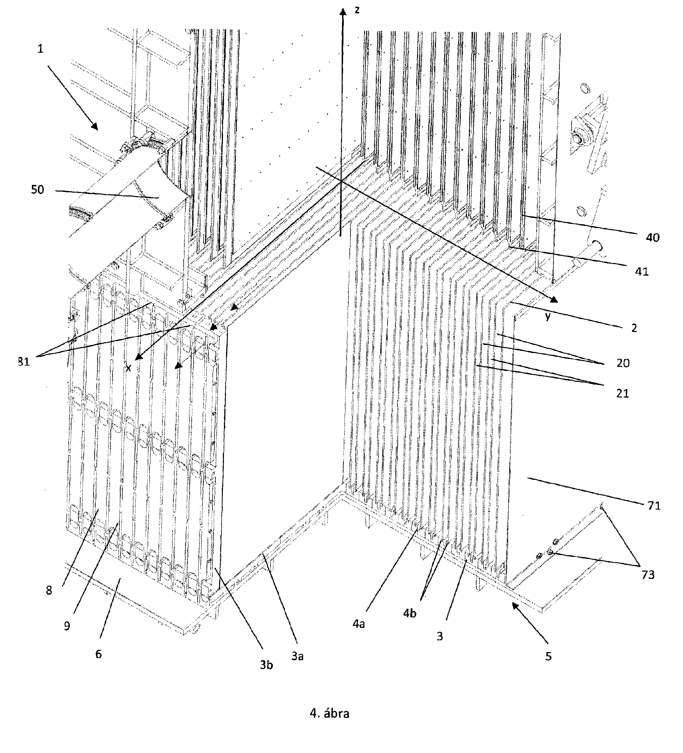

In Fig. 4 the reaction chamber 1 is shown in a partially cut-out, perspective view, with the loading container 5 being in an intermediate phase of loading. The cut-out is made such that one quarter of the chamber is removed at one corner of the reaction chamber 1 and the important elements inside are also visible. The reaction chamber 1 is rotated by -90° degree with respect to the view of Fig. 3, which can be observed from the different orientation of the substrates 2. In order to provide better visibility of the change of orientation x, y and z directions are also shown. The x, y, z directions form here as well a right-handed coordinate system, however the x and y axes point to other directions, rotated by -90° degree.

From the upper part of the reaction chamber 1 planar, rectangular, spaced apart, equidistant and parallel electrodes 40 are suspended towards the bottom and during the upwards movement of the frames each electrode along its width reaches into recesses 4a of the supporting frames 3 and the recesses support and guide the electrodes. In this manner an interpositioned, comb-shaped plate structure is formed, in which two substrates 2 always enclose an electrode 40, and on the side of the substrates 2 opposite to the electrodes 40 a volume suitable for gas flow is formed. Due to this advantageous arrangement during introduction into the reaction chamber 1 the substrates 2 line up in a comb-shaped manner between the electrodes 40 which are fixed in their positions in the chamber 1. Between the substrates 2 volume 20 and volume 21 are alternating. The volumes 20 are reaction volumes for reaction gases. Into volumes 21 the electrodes 40 are inserted. Loading is completed when the substrates 2 are all the way slid into the reaction chamber 1 with the electrodes 40 interpositioned between them. In this position the flattened part 41 (rims) of each electrode 40 fits into recess 4a of the respective supporting frame 3 and is firmly supported and guided therein. In each recess 4a the respective electrode 40 is inserted with a small play such that sufficiently large space is left for deformations due to thermal dilatation. Even further, electrode 40 is inserted with a small play into volume 21 between two substrates 2 such that sufficiently large space is left between the substrate 2 and the electrode 40 for deformation due to thermal dilatation. As it has been shown earlier recess 4a is deeper than the two recesses 4b encompassing it. Consequently, in a completely loaded position the electrodes 40 slightly reach over the surfaces of the substrates 2. In this manner we achieve that in the region of the substrate 2 surfaces inhomogeneous plasma conditions and related fluctuations and transient processes of the deposition conditions are suppressed and the quality and thickness of the deposited layer is homogeneous.

Thus, in the fully loaded position the electrodes 40 and the substrates 2 which are completely slid between them form a sandwich structure in which e.g. the following come periodically in a consecutive order: a substrate 2 placed into a recess 4b corresponding to a first supporting frame 3, an electrode 40 placed into recess 4a, again a substrate 2 placed into recess 4b, then the volume 20 between substrates 2 of two adjacent supporting frames 3 (which volume is eventually a broadened extension of the gap 4c between two adjacent supporting frames 3 and extends further between the substrates 2), then a subsequent substrate 2 inserted into recess 4b corresponding to a supporting frame 3 next to the first one, an electrode 40 inserted into recess 4a and again a substrate 2 inserted into recess 4b etc. In the loading container 5 introduced into the reaction chamber 1 this periodic structure is repeated in finite number.

In Fig. 4 it is also shown that the loading container 5 is fastened along its bottom to a bottom closing lid 6. There is disposed a fastening plate 71 on the outermost supporting frames 3 which limit the loading container 5 from the sides and releasable fastening elements, e.g. screws which firmly hold in place the fastening plate 71 with respect to the closing lid 6 are also shown.

A main feature of the reaction chamber 1 is that the electrodes 40 are suspended from the inner side of the upper part of the reaction chamber 1 - using directions of Fig. 4. Electrode 40 comprises two threaded bolts 43 which are protruding from the upper part of the electrode 40. Said threaded bolts 43 are introduced into holes provided in the upper lid of the reaction chamber 1 and said threaded bolts 43 are fastened to the lid of the reaction chamber 1 by releasable connecting elements, e.g. by screws. The threaded bolts 43 serve - beyond fastening - as electric connectors for the electric power supply of the heater wiring to be described in detail later. At the upper edge of the electrode 40 a further connecting element 44 is disposed for connecting the RF generator denoted by reference number G. The suspension of electrodes 40 is realized by means of releasable connection, however during normal operation conditions e.g. between two CVD cycles these connections do not need to be disconnected. This means that the heating F cables and the connections of the radio frequency generator G need not to be disconnected, which makes the implementation of the CVD process easier, more reliable and thus, productivity is improved.

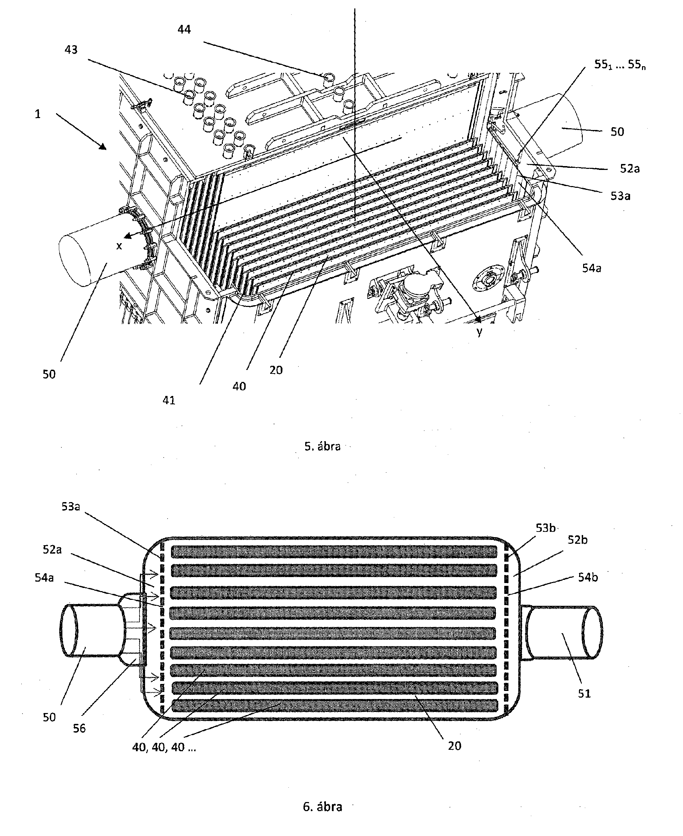

According to an advantageous embodiment, to each lateral frame part 3b of the supporting frames 3 ribs 8 are attached by means of releasable connecting means, e.g. bolts. Each rib 8 is responsible for holding together three supporting frames 3. The ribs 8 are provided with openings, e.g. by grooves 9 which are positioned so as to overlap with the gaps 4c between the adjacent supporting frames 3 when the ribs 8 are mounted onto the frames. Thanks to this arrangement during the CVD process the gases entering the reaction chamber 1 must flow through the grooves 9 of the ribs 8 and subsequently through the gaps 4c between adjacent supporting frames 3 and by flowing further towards the inside of the loading container the reaction gases enter into the volumes 20 extending along the substrate 2 surfaces to be deposited. Thus, these volumes 20 form reaction volumes, which serve for plasma generation and serve as a place of chemical reactions. Ribs 8 are attached to the lateral frame parts 3b of the supporting frames 3. One rib 8 accounts for the connection of three supporting frames 3. In this figure the boarder lines 81 between the ribs are visible. Further, between the grooves 9 of the ribs 8, in the gaps 4c between the supporting frames 3 and in the volumes 20 between two substrates 2 along the path marked by dashed arrows a free gas flow channel is formed. By this arrangement during the CVD process gases can flow through the reaction chamber 1. The ribs 8, the grooves 9 and volumes 4c and 20 all play an important role in the gas distribution system of the reaction chamber 1, the structure of which is shown in detail in Figs. 5 to 7.

In Fig. 5 the reaction chamber 1 is shown in a partially cut-out, perspective view, with the loading container 5 being in an intermediate phase of loading. The cut-out is made such that one quarter of the chamber is removed at a one corner of the reaction chamber 1 and the important elements inside are also visible. The reaction chamber 1 is rotated by -90° degree with respect to the view of Fig. 1, which can be observed from the different orientation of the substrates 2. In order to provide better visibility of the change of orientation x, y and z directions are also shown. The x, y, z directions form here as well a right-handed coordinate system, however the x and y axes point to other directions, rotated by -90° degree. From the upper part of the inner side of the reaction chamber 1 planar, rectangular, spaced apart, equidistant and parallel electrodes 40 and volumes 20 extending between the electrodes 40 are arranged, the electrodes 40 and volumes 20 alternating in a direction parallel to axis y.

On two opposite sidewalls of the reaction chamber 1 perpendicular to the x axis an inlet channel 50 for introducing the reaction gases and an outlet channel 51 for removing the reaction byproducts are arranged. Between the inlet channel 50 and the outlet channel 51 the direction of gas flow is parallel to the plane of electrodes 40 and (not shown in this figure) also to the plane of substrates 2 if the loading container is fully introduced. The inlet channel 50 can be constructed so that it comprises more than one inlet pipes with smaller cross-section. Through the smaller cross section inlet pipes various gases of different character can be introduced - as required by the thin layer deposition processes in the reaction chamber 1 - into the reaction volumes 20 of the reaction chamber 1.

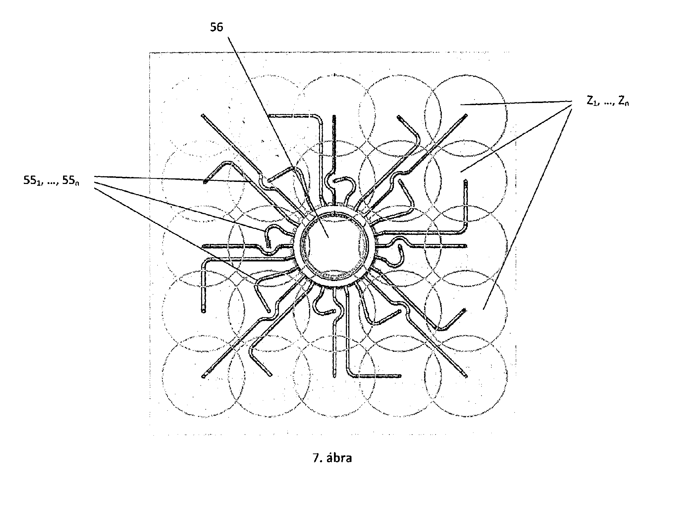

On the basis of the perspective view of Fig. 5 and the schematic top view of Fig. 6 the structure and operation principle of the gas distribution system is as follows. An inlet channel 50 is disposed on one side of the reaction chamber 1, along axis x in Fig. 5, in order to lead in the reaction gases taking part in the reaction. In Fig. 6 we see that the inlet channel 50 is connected to a mixing chamber 56 which is built into a respective sidewall of the reaction chamber 1. From the mixing chamber conduits 55₁, ..., 55ₙ are extending radially. Each conduit 55₁, ..., 55ₙ comprises a radially directed, optionally linear, alternatively arcuated, curved or bended portion as a first end, wherein the radial portions of said conduits 55₁, ..., 55ₙ spread out to all directions running in the same plane. The other end of each conduit 55₁, ..., 55ₙ can be bended, each in different manner as shown in Fig. 7 and as explained in the below description. Lengths of the conduits 55₁, ..., 55ₙ can be different. The other ends of the conduits 55₁, ..., 55ₙ terminate in different points of the sidewall of the reaction chamber 1, moreover, conduits 55₁, ..., 55ₙ are terminated in a distribution chamber 52a, directly at the side of the reaction chamber 1. The 52a distribution chamber is limited from one side by the sidewall of the reaction chamber 1 and on the other side by a 53a distribution plate. In the 53a distribution plate small 54a openings are formed. Gases flowing towards the reaction chamber 1 enter the reaction volume through said openings 54a. Using the elements of Fig. 4 the flow path of the gases starts at the inlet channel 50, goes to the mixing chamber 56 and from the mixing chamber 56 leads to the distribution chamber 52a through conduits 55₁, ..., 55ₙ. Only at this point can the gases enter the reaction chamber 1 through said openings 54a of the distribution plate 53a positioned on the downstream side of the distribution chamber 52a; in the reaction chamber 1 the gases enter into recesses 9 between the ribs 8 of the loading container 5; then into the volumes 4c between the supporting frames 3 of the loading container 5, and further, from volumes 4c - forced by the effect of an underpressure - enter the reaction volumes 20 disposed between the substrates 2.

Along axis x, on the opposite side of the chamber a similar structure is arranged in order to facilitate the homogeneous draining of reaction byproducts. There is disposed a collecting plate 53b for gases exiting the reaction volumes 20 through the volumes 4c and grooves 9. The collecting plate 53b comprises openings 54b. A collecting chamber 52b is arranged on the downstream side of the collecting plate 53b. The collecting chamber 52b opens directly into the outlet channel 51, since on the downstream side there is no need for the radial conduits 55₁, ..., 55ₙ which homogenize the gas flow. On the distribution plate 53a and the collecting plate 53b the respective openings 54a and 54b are distributed such that the openings 54a and 54b are placed next to each other in the vertical direction (direction z in Fig. 5) at very small distances, i.e. 0.2 mm to 10 mm. Such columns extend through the whole height of the distribution plate 53a and the collecting plate 53b, respectively. There is a number of columns in a periodic structure formed by the plurality of openings 54a and 54b adjacent to each other. The period of columns is exactly equal to the distance of grooves 9 formed in the ribs 8 of the loading container 5, as well as the distance of volumes 4c extending between the supporting frames 3 of the loading container 5. With this arrangement it is advantageously achieved that when the structure is erected the columns formed by the openings 54a of the distribution plate 53a and the columns formed by the openings 54b of the collecting plate 53b completely overlap with the grooves 9 formed in the ribs 8 of the loading container 5, as well as with the volumes 4c extending between the supporting frames 3. In this manner an easily accessible, clear gas flow channel is formed for the process gases.

The core idea of the invention is the provision of the mixing chamber 56 on the inlet side of the reaction chamber and the conduits 55₁, ..., 55ₙ extending radially from the mixing chamber 56. A possible embodiment of conduits 55₁, ..., 55ₙ is depicted in Fig. 7. In this figure the mixing chamber 56 and the conduits 55₁, ..., 55ₙ are seen from direction x. The radial portions of the conduits 55₁, ..., 55ₙ run in the y-z plane. The first,end of the conduits 55₁, ..., 55ₙ is attached to the mixing chamber 56. Note, that the inlet channel 50 is connected to the upstream side of the mixing chamber 56 and - since in a single reaction cycle optionally more reaction gases must be let in - each type of the reaction gases is connected to the mixing chamber 56 independently. In case of introducing a gas mixture of more than one reaction gases into the reaction chamber 1 blending of such gas mixture is effected in the mixing chamber 56. Blending can continue in the conduits 55₁, ..., 55ₙ such that in the distribution chamber 52a a gas composition suitable for carrying out the intended reaction is obtained and this will enter the reaction volumes 20. The conduits 55₁, ..., 55ₙ may be different in form. They are shaped such that each conduit 55₁, ..., 55ₙ ends up at the sidewall of the reaction chamber 1 approximately in the middle of a zone Z₁, ..., Zₙ, which is part of a plurality of imaginary, equidistant, circular zones Z₁, ..., Zₙ on the sidewall of the chamber. To achieve this arrangement, the length of the conduits 55₁, ..., 55ₙ can be different, i.e. shorter conduits 55₁, ..., 55ₙ lead to closer zones Z₁,..., Zₙ and longer conduits to those that are further. Further, to achieve this arrangement, conduits 55₁, ..., 55ₙ may be of different shapes, i.e. may be bent to a different extent. It is conceivable to have a conduit 55₁, ..., 55ₙ which has a linear end reaching into the distribution chamber 52a; on the other hand it is possible to have another conduit 55₁, ..., 55ₙ which has an articulated end, which is bent in a direction perpendicular to the x axis and reaches into the distribution chamber 52a; further, it is also possible to have a conduit 55₁, ..., 55ₙ which has an end reaching into the distribution chamber 52a and protruding from plane y-z; it is also conceivable to make a conduit 55₁, ..., 55ₙ which has an articulated portion not only at its terminal end close to the distribution chamber 52a, but an arbitrary portion thereof is curved, articulated, or provided with a loop form (in order to avoid contact with another conduit 55₁, ..., 55ₙ or conduits 55₁, ..., 55ₙ). It is also feasible that the curve, arc or loop lays not exactly in the plane (y-z plane) perpendicular to axis x (also in order to avoid contact with another conduit 55₁, ..., 55ₙ or conduits 55₁, ..., 55ₙ). Due to excessive gas flow rates it is not a critical feature from the viewpoint of homogeneity of the gas flow to prepare conduits 55₁, ..., 55ₙ with the same length.

According to the solutions of the prior art, there is no mixing chamber 56 disposed downstream to the inlet channel (50), and the conduits 55₁, ..., 55ₙ are missing. Without the mixing chamber 56 the gases are blended in a distribution volume, however it can be well expected that in this arrangement the flow rate of gases is bigger in the region of the inlet channel 50, and smaller in regions closer to the sidewalls, which does not support homogeneous gas distribution. The mixing chamber 56 and the conduits 55₁, ..., 55ₙ starting therefrom provide for the homogeneous distribution of gases among the zones Z₁, ..., Zₙ on the whole side surface (in this embodiment y-z plane) of the reaction chamber 1.

A further important feature of the present invention is that (i) connections of the generator G and the heater F , (ii)the gas distribution system for providing a process gas flow and (iii) the bottom closing lid 6 are each arranged according to different x, y, z orthogonal directions of the reaction chamber 1 on its six faces. Thus, different functions of the reaction chamber 1 are separated according to different spatial directions.

Using x, y and z directions according to Fig. 4 the most preferred embodiment is where the loading container 5 and the closing bottom 6 attached thereto are moved along the vertical z axis. Further, the connections coupling the electrodes 40 to the heater F and the generator G are also realized along the z axis, e.g. on the upper side of the chamber opposite to the bottom closing lid 6. In this embodiment the gas flow channel is formed in the x direction and the introduction of reaction gases and draining of reaction byproducts is realized in the x direction on two opposite faces of the chamber, namely with the aid of the inlet channel 50 and the outlet channel 51. In this manner it is advantageously achieved that the loading/unloading direction of the chamber 1 is orthogonal to the gas flow direction. By implementing different functions in different directions various elements of the reaction chamber 1 and processes carried out by said various elements are well separated from each other.

It is also conceivable to have an alternative geometrical arrangement e.g. in which the loading container 5 and the closing bottom 6 attached thereto are moved along the vertical z axis, the connections coupling the electrodes 40 to the heater F and the generator G are realized on a side along the x axis and the gas flow channel is formed in the y direction so that the introduction of reaction gases and draining of reaction byproducts is realized in the y direction on two opposite faces of the chamber.

## Claims

1. Gas distribution system for use in a reaction chamber (1) for deposition of a semiconductor layer or layer structure on the plurality of substrate (2) surfaces, the reaction chamber (1) comprising a body with an inner volume and a lid and a closing bottom lid (6), in the inner volume rectangular substrates (2) are arranged spaced apart from each other and electrodes (40) suitable for providing high-frequency electromagnetic field in order to deposit a thin material layer are disposed between the substrates (2); each electrode (40) is disposed in a spaced-apart relationship adjacent to the surface of a substrate (2) not to be deposited and the space extending between the substrate (2) surfaces to be-deposited provide flow channels making available the laminar flow of reaction gases between two opposite sides of the chamber (1), the opposite electrodes (40) are connected to a high-frequency generator (G) and the closed inner volume of the chamber (1) is provided with a heating element (F), further the gas distribution system has an inlet channel (50), a distribution chamber (52a) and a distribution plate (53a) and further a collecting plate (53b), collecting chamber (52b) and an outlet channel (51) **characterized in that** between the inlet channel (50) and the distribution chamber (52a) there is disposed
- a mixing chamber (56) for improving the homogeneous blending of reaction gases wherein the mixing chamber is separated from the distribution chamber (52a) by a wall portion and
- conduits (55₁, ..., 55ₙ) for improving the homogeneous blending of reaction gases having their first end in the mixing chamber (56) and their terminal end in the distribution chamber (52a).

2. Gas distribution system according to claim 1 **characterized in that** on the side of the reaction chamber (1) facing the inlet channel (50) imaginary, equidistant zones (Z₁, ..., Zₙ) are formed and the conduits (55₁, ..., 55ₙ) are shaped so that each conduits (55₁, ..., 55ₙ) is terminated in the middle of the respective zone (Z₁, ..., Zₙ).

3. Gas distribution system according to claim 1 or 2 **characterized in that** to the closing lid (6) of the reaction chamber (1) supporting frames (3) are fastened wherein the substrates (2) are surrounded and supported along their side edges and along their bottom by the supporting frames (3), the supporting frames (3) are connected to each other by means of a coupling structure comprising ribs (8) provided with grooves (9) and in the assembled frame structure gaps (4c) are disposed between the supporting frames (3); and on the distribution plate (53a) and collecting plate (53b) of the gas distribution system a plurality of holes (54a, 54b) is provided, the holes (54a, 54b) are aligned in columns, and when the supporting frames (3) are loaded into the reaction chamber (1) holes (54a, 54b) of column shape, the grooves (9) of the ribs (8) and the gaps (4c) between the supporting frames (3) are in overlap with each other and form a gas flow channel.

4. Gas distribution system according to claim 1 **characterized in that** the gas flow channel opens into two opposite sidewalls which are perpendicular both to the upper lid and the bottom closing lid (6) and within the reaction chamber (1) the gas flow channel extends parallel to the plane of the substrates (2) and electrodes (40).

5. Gas distribution system according to claim 1 **characterized in that** in.case a gas mixture of a number of different process gases is used, the feeding lines of the individual process gases lead to a portion of the inlet channel (50) which is disposed upstream relative to the mixing chamber (56).

## Patentansprüche

1. Gasverteilungssystem zur Verwendung in einer Reaktionskammer (1) zur Abscheidung einer Halbleiterschicht oder Schichtstruktur auf eine Vielzahl von Substrat (2) Oberflächen, die Reaktionskammer (1) umfassend einen Körper mit einem Innenvolumen und einem Deckel und einem schließenden unteren Deckel (6), wobei in dem Innenvolumen rechteckige Substraten (2) in einer zueinander beabstandeten Beziehung angeordnet sind und wobei Elektroden (40), die zur Herstellung eines zur Abscheidung einer dünnen Materialschicht hochfrequenten elektromagnetischen Feld geeignet sind, zwischen den Substraten (2) angeordnet sind; jede Elektrode (40) in einer beabstandeten Beziehung von- und angrenzend ander nicht-abzuscheidenden Oberfläche eines Substrats (2) angeordnet ist und der Abstand zwischen den abzuscheidenden Substrat (2) Oberflächen Strömungskanäle bereitstellt, die die laminare Strömung der Reaktionsgase zwischen zwei gegenüberliegenden Seiten der Kammer (1) ermöglichen, die gegenüberliegenden Elektroden (40) sind mit einem Hochfrequenzgenerator (G) verbunden und das geschlossene Innenvolumen der Kammer (1) mit einem Heizungselement (F) vorgesehen ist, außerdem umfasst das Gasverteilungssystem einen Einlasskanal (50), eine Verteilungskammer (52a) und eine Verteilungsscheibe (53a) und ferner eine Sammeln Scheibe (53b), eine Sammeln Kammer (52b) und einen Austrittskanal (51) **dadurch gekennzeichnet, dass**
zwischen dem Einlasskanal (50) und der Verteilungskammer (52a)
- eine zur Verbesserung der homogenen Vermischung der Reaktionsgase Mischkammer (56) angeordnet ist, wobei die Mischkammer von der Verteilungskammer (52a) durch einen Wandabschnitt getrennt ist, und
- zur Verbesserung der homogenen Vermischung der Reaktionsgase Leitungen (55₁, ..., 55ₙ) angeordnet sind, die ihr erstes Ende in der Mischkammer (56) und ihr abschließendes Ende in der Verteilungskammer (52a) haben.

2. Gasverteilungssystem nach Anspruch 1 **dadurch gekennzeichnet, dass** auf der Seite der Reaktionskammer (1), die gegenüber dem Einlasskanal (50) ist, imaginäre äquidistante Zonen (Z₁, ..., Zₙ) gebildet sind und die Leitungen (55₁, ..., 55ₙ) so geformt sind, dass jede Leitungen (55₁, ..., 55ₙ) in der Mitte der jeweiligen Zone (Z₁, ..., Zₙ) beendet.

3. Gasverteilungssystem nach Anspruch 1 oder 2 **dadurch gekennzeichnet, dass** an dem schließenden Deckel (6) der Reaktionskammer (1) Tragrahmen (3) befestigt sind, wobei die Substraten (2) entlang ihrer Seitenkanten und entlang ihrer Unterseite durch die Tragrahmen (3) umgeben und gestützt sind, die Tragrahmen (3) durch eine Kupplungsstruktur miteinander verbunden sind, die Rippen (8) umfasst, die mit Nuten (9) vorgesehen sind, und im zusammengesetzten Rahmenstruktur zwischen den Tragrahmen (3) Lücken (4c) angeordnet sind; und auf der Verteilungsscheibe (53a) und Sammelns Scheibe (53b) des Gasverteilungssystem a eine Vielzahl von Löchern (54a, 54b) vorgesehen ist, die Löchern (54a, 54b) sind in Spalten ausgerichtet, und, wenn die Tragrahmen (3) in die Reaktionskammer (1) geladen wird, die Löchern (54a, 54b) mit Spalten Form, die Nuten (9) der Rippen (8) und die Lücken (4c) zwischen den Tragrahmen (3) einander überlappen und einen Gasströmungskanal ausbilden.

4. Gasverteilungssystem nach Anspruch 1 **dadurch gekennzeichnet, dass** der Gasströmungskanal in zwei gegenüberliegenden Seitenwänden sich öffnet, die zu dem oberen Deckel und dem unteren schließenden Deckel senkrecht sind, und innerhalb der Reaktionskammer (1) erstreckt sich der Gasströmungskanal parallel zur Ebene der Substrate (2) und Elektroden (40).

5. Gasverteilungssystem nach Anspruch 1 **dadurch gekennzeichnet, dass** wenn eine Gasmischung aus verschiedener Prozessgase verwendet wird, die Speiseleitungen der einzelnen Prozessgase zu einem Abschnitt des Einlasskanals (50) fuhren, der stromaufwärts der Mischkammer (56) angeordnet ist.

## Revendications

1. Un système de distribution de gaz pour utilisation dans une chambre de réaction (1) pour le dépôt d'une couche semiconductrice ou d'une structure à couche sur la pluralité de surfaces de substrat (2), la chambre de réaction (1) comprenant un corps avec an volume intérieur et un couvercle et un couvercle inférieur de fermeture (6), dans le volume intérieur des substrats (2) rectangulaires sont disposés espacés les uns des autres et des électrodes (40) utilisables pour fournir un champ électromagnétique à haute fréquence de manière à déposer une couche de matériau fine sont disposées entre les substrats (2); chaque électrode (40) est disposée de manière distancée adjacente à la surface d'un substrat (2) à ne pas être déposé et l'espacement entre les surfaces de substrat (2) à être déposé fourni des canaux d'écoulement permettant l'écoulement laminaire des gaz de réaction entre deux cotées opposées de la chambre (1), les électrodes (40) opposées sont connectées à un générateur (G) à haute fréquence et le volume intérieur fermé de la chambre (1) est fourni avec un élément de chauffage (F), en outre le system de distribution de gaz a un canal d'entrée (50), une chambre de distribution (52a) et une plaque de distribution (53a) et en outre une plaque de collection (53b), une chambre de collection (52b) et un canal de sortie (51) **caractérisé en ce que** entre le canal d'entrée (50) et la chambre de distribution (52a)
- un chambre de mélange (56) est placée pour améliorer le mélange homogène des gaz de réaction dans lequel la chambre de mélange est séparée de la chambre de distribution (52a) par une portion de mur et
- conduits (55₁, ..., 55ₙ) sont placés pour améliorer le mélange homogène des gaz de réaction ayant leur première extrémité dans la chambre de mélange (56) et leur extrémité finale dans la chambre de distribution (52a).

2. Système de distribution de gaz selon la revendication 1 **caractérisé en ce que** sur le bord de la chambre de réaction (1) faisant face au canal d'entrée (50) des zones (Z₁, ..., Zₙ) imaginaires et équidistantes sont formées et les conduits (55₁, ..., 55ₙ) sont formés de telle manière que chaque conduits (55₁, ..., 55ₙ) est terminé au milieu de la zone (Z₁, ..., Zₙ) respective.

3. Système de distribution de gaz selon la revendication 1 ou 2 **caractérisé en ce que** au couvercle (6) de fermeture de la chambre de réaction (1) des cadres de soutien (3) sont fixés dans lequel les substrats (2) sont entourés et maintenus au long des leurs bords latéraux et au long de leurs dessous par les cadres de soutien (3), les cadres de soutien (3) sont connectés les uns avec les autres par moyens d'une structure de couplage comprenant des nervures (8) fournis avec des rainures (9) et dans la structure de cadre assemblée des écarts (4c) sont disposés entre les cadres de soutien (3); et sur la plaque de distribution (53a) et la plaque de collection (53b) du système de distribution de gaz une pluralité de trous (54a, 54b) sont fournis, les trous (54a, 54b) sont alignés en colonnes, et quand les cadres de soutien (3) sont chargés dans la chambre de réaction (1) trous (54a, 54b) en forme de colonne, les rainures (9) des nervures (8) et les écarts (4c) entre les cadres de soutien (3) sont en chevauchement les uns avec les autres et forment un canal d'écoulement de gaz.

4. Système de distribution de gaz selon la revendication 1 **caractérisé en ce que** le canal d'écoulement de gaz s'ouvre dans deux flancs opposés qui sont perpendiculaires soit au couvercle supérieur et au couvercle (6) de fermeture inférieur et dans la chambre de réaction (1) le canal d'écoulement de gaz s'étend de façon parallèle au plan des substrats (2) et des électrodes (40).

5. Système de distribution de gaz selon la revendication 1 **caractérisé en ce que** dans le cas où un mélange de gaz avec un nombre de diffèrent gaz de procédé est utilisé, les lignes d'alimentation des gaz de procédé individuelles conduisent à une portion du canal d'entrée (50) qui est disposée en amont par rapport à la chambre (56) de mélange.
